# EUROPEAN PATENT APPLICATION

(11) **EP 0 526 220 A1**
(43) Date of publication of application: **03.02.1993**
(21) Application number: 92306977.7
(22) Date of filing: 30.07.1992
(51) Int. Cl.: H01L 33/00, H01S 3/19

(54) **Light emitting diode having small emission-spot**

(30) Priority: 02.08.1991 US 739558
(71) Applicant: MOTOROLA, INC., Schaumburg, IL 60196 (US)
(72) Inventor: Morgan, Damon L., Phoenix, Arizona 85044 (US); Moyer, Curtis D., Phoenix, Arizona 85044 (US); Satyanarayan, Arumugam, Mesa, Arizona 85204 (US)
(74) Representative: Dunlop, Hugh Christopher

(57) **Abstract**

A light emitting diode (LED) (10) having a small emission-spot includes an isolation layer (12) which restricts current flow to a small area (23) of the diode (10). The LED (10) also has a barrier layer (13) that provides an energy barrier which prevents minority carrier current current flow in order to minimize the size of the LED's (10) emission-spot. The barrier layer's (13) thickness is between a maximum and a minimum limit thereby resulting in an LED (10) with a small emission-spot, high bandwidth, and high efficiency.

## Description

### Background of the Invention

The present invention relates, in general, to light emitting diodes, and more particularly, to a novel light emitting diode having a small emission-spot.

In the past, light emitting diodes (LEDs) have been used for a variety of applications including optical sources in many types of optical communication systems. An increased need of operating at greater distances has placed increased emphasis on obtaining high coupling efficiency between an LED and an optical fiber. Increased coupling efficiency generally requires the diameter of the area from which light is emitted (the LED's emission-spot) to be smaller than the diameter of the optical fiber which is coupled to the LED.

One disadvantage of previous small emission-spot LEDs is the amount of drive current required for a predetermined power output. Typically an LED with a small emission-spot (generally less than about 15 microns) requires a drive current in excess of about 100 milliamps to produce approximately 1 milliwatt of output power. An additional disadvantage of previous small emission-spot LEDs, is the LED's bandwidth. The maximum effective operating frequency generally is less than approximately 70 megahertz.

Accordingly, it is desirable to have an LED that has a small emission-spot (less than approximately 15 microns), that has an efficient power output, and that has a high bandwidth.

### Summary of the Invention

Briefly stated, the present invention includes a light emitting diode (LED) that has an isolation layer which restricts current flow to a small area of the diode. The LED also has a barrier layer that provides an energy barrier which prevents minority carrier current flow in the isolation layer in order to minimize the size of the LED's emission-spot. The barrier layer's thickness is between a maximum and a minimum limit thereby resulting in an LED with a small emission-spot, high bandwidth, and high efficiency.

### Brief Description of the Drawings

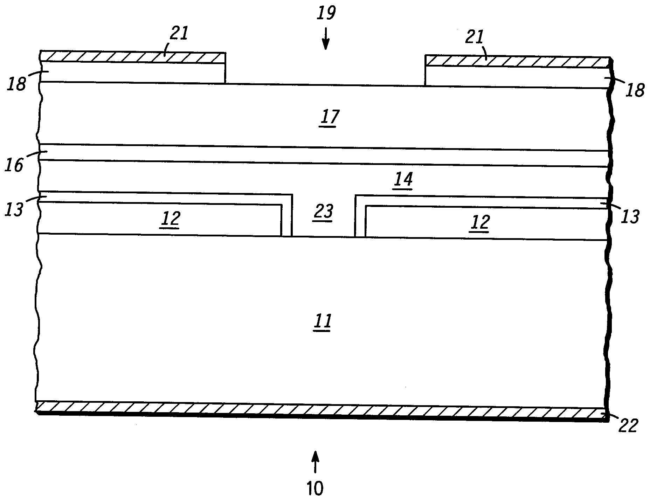

The sole Figure is an enlarged cross sectional view of a preferred embodiment of an LED in accordance with the present invention.

### Detailed Description of the Drawings

The sole Figure illustrates a preferred embodiment of a high efficiency light emitting diode (LED) 10 that has a small emission-spot. LED 10 is formed from a silicon doped N-type gallium arsenide (GaAs) substrate 11. A portion of substrate 11 is used to form a P-type isolation layer 12 by diffusing a mobile P-type dopant a predetermined distance into substrate 11. Suitable materials that could be utilized for such a mobile dopant include zinc, cadmium, beryllium, and magnesium. In the preferred embodiment, zinc is diffused a distance between approximately 0.8 to 1.0 micron into substrate 11 in order to form isolation layer 12. The N-type to P-type interface forms a junction that prevents current from flowing through isolation layer 12 to substrate 11. In order to provide a gateway that permits current flow through substrate 11, an opening 23 is formed through isolation layer 12. Because of the current blocking characteristic of isolation layer 12, opening 23 assists in confining current flow to a small section of LED 10 thereby restricting the size of the emission-spot of LED 10. In the preferred embodiment, opening 23 has a width between approximately 12 microns and 65 microns and results in an emission-spot that correspondingly ranges from about 12.5 to 66 microns.

The remaining layers of LED 10 include a P-type AlGaAs barrier layer 13, an N-type AlGaAs injection layer 14, a P-type AlGaAs active layer 16, a P-type AlGaAs window layer 17, and a P-type GaAs cap layer 18. Layers 14, 16, 17, and 18 are grown on isolation layer 12 by liquid phase epitaxy (LPE), molecular beam epitaxy (MBE), metal organic chemical vapor deposition (MOCVD), or other similar epitaxial methods that can be utilized to form a double heterostructure that is lattice matched to substrate 11. Barrier layer 13 is formed as the elevated temperatures employed during the epitaxial growth of layers 14, 16, 17, and 18 cause a portion of the mobile dopant to out-diffuse from isolation layer 12. As the dopant diffuses outward, a portion of N-type AlGaAs injection layer 14 that is adjacent to isolation layer 12 is converted to P-type AlGaAs barrier layer 13.

Injection layer 14 fills opening 23, and covers barrier layer 13 with about 1.5 to 2.5 microns of N-type aluminum gallium arsenide (AlGaAs). The aluminum content of injection layer 14 along with layers 16 and 17 is chosen to create an energy level within the conduction band that confines minority carriers to active layer 16, and that facilitates forming light at a wavelength which can pass relatively unaffected through window layer 17. In the preferred embodiment, injection layer 14 has an aluminum mole fraction of approximately 25 per cent (Al_{0.25}Ga_{0.75}As), active layer 16 has an aluminum mole fraction of about 3 per cent (Al_{0.03}Ga_{0.97}As), and window layer 17 has an aluminum mole fraction of about 35 per cent (Al_{0.35}Ga_{0.65}5As).

The thickness of barrier layer 13 is controlled by the doping concentration of isolation layer 12 which provides the doping source for barrier layer 13, the aluminum content of injection layer 14 which determines the diffusion rate in layer 14, and the time and temperature used in forming epitaxial layers 14, 16, 17, and 18. In the preferred embodiment, zinc is applied to a surface concentration greater than 1x10¹⁹ which results in barrier layer 13 having a thickness between approximately 800 and 3700 angstroms (Å). Although the thickness of barrier layer 13 reduces the width of opening 23, the reduction is typically negligible compared to the size of opening 23. In contrast, the thickness of barrier layer 13 is significant compared to the thickness of isolation layer 12. This thickness relationship is critical to the current blocking capability provided by the combination of isolation layer 12 and barrier layer 13. Consequently it is important to the improvement in spot size, bandwidth, and efficiency that are provided by LED 10 as will be seen hereinafter.

Prior to the epitaxial growth of layers 14, 16, 17, and 18, the surface of isolation layer 12 and the exposed surface of substrate 11 are thoroughly cleaned. This cleaning is necessary to remove oxidation that would prevent adherence of the epitaxial layers to isolation layer 12 and substrate 11. During the cleaning operation, care must be taken to minimize the amount of doped material that is removed from the surface of isolation layer 12. Removal of excessive amounts of P-doped material could adversely affect the out-diffusion of the mobile P-type dopant into barrier layer 13, and reduce the thickness of barrier layer 13. In the preferred embodiment, a mixture of approximately 40 parts by volume of sulfuric acid (H₂SO₄), one part by volume of hydrogen peroxide (H₂O₂), and one part by volume of water (H₂O) is applied to isolation layer 12 for a period of approximately 20 seconds. The cleaning procedure used in this preferred embodiment removes only about 300 angstroms of diffused P-type material from the surface of isolation layer 12.

After the formation of layers 13, 14, 16, 17, and 18, a portion of cap layer 18 is removed to create an emission opening 19 that allows light, generated in active layer 16, to be emitted from LED 10. Typically, emission opening 19 is created by applying conductor material to form an ohmic contact with cap layer 18, then forming an opening to create an anode electrode 21 on cap layer 18. Emission opening 19 is then formed by using anode electrode 21 as a mask while etching cap layer 18. In most instances, emission opening 19 is centered over opening 23. In the preferred embodiment, emission opening 19 is created by forming anode electrode 21 and etching gallium arsenide cap layer 18 with a citric acid solution that includes 10 parts citric acid, 1 part hydrogen peroxide, and 1 part deionized water (all by volume). Although the citric acid solution is an effective etchant of gallium arsenide, it does not etch aluminum gallium arsenide window layer 17 and provides an effective method of removing only gallium arsenide from cap layer 18. Also in this embodiment, anode electrode 21 is a bi-metallic layer of chrome that is covered with gold. A cathode electrode 22 is also applied in ohmic contact with substrate 11. In the preferred embodiment, electrode 22 is a tri-layer structure of germanium doped gold that is covered with a layer of nickel followed by a layer of gold.

In operation, current flows from electrode 21 through opening 23 to electrode 22. In active layer 16, the current supplies minority carriers for electron-hole recombination thereby producing photons. Most of the photons travel relatively unaffected through the large band gap lattice structure of layers 13, 14, and 17. But, as photons travel through the lattice structures of small band gap layers 11, 12, and 18, the photons are absorbed and generate electron-hole pairs. In isolation layer 12, electrons, or minority carriers, generated by the absorption reside in the conduction band of isolation layer 12. The large band gap of barrier layer 13 functions as an energy barrier that prevents these electrons from flowing through barrier layer 13 to injection layer 14. Therefore, barrier layer 13 prevents minority carriers, generated by photon absorption, from flowing thereby preventing minority carrier current flow.

It has been found that the thickness of barrier layer 13 is crucial to preventing minority carrier current flow. If the energy barrier formed by barrier layer 13 is too thin, some electrons can tunnel through the energy barrier and provide a path for parasitic or minority carrier current flow. Since this minority carrier current would flow through the portion of active layer 16 that is above isolation layer 12, photons would be stimulated and light would be produced in regions of active layer 16 that are distant from opening 23 thereby increasing the emission-spot size of LED 10. As this minority carrier current flowed and generated parasitic photons outside the region of opening 23, the parasitic photons would create more minority carrier current which would create more parasitic photons which would create more minority carrier current, etc. Such a minority carrier current flow would eventually cause photon emissions from the entire width of active layer 16 which would result in an LED with a large emission-spot, and high leakage current. Consequently, it is important that the thickness of barrier layer 13 be greater than a critical minimum limit in order to prevent minority carrier current flow and form a small emission-spot for LED 10. In the preferred embodiment of LED 10, barrier layer 13 has a minimum thickness of approximately 800 angstroms resulting in an energy barrier thickness that prevents electron tunneling thereby preventing minority carrier current flow, and providing a minimum emission-spot for LED 10. It has also been found that if the thickness of barrier layer 13 is too great, the series resistance created along the current flow path through opening 23 is increased resulting in a corresponding decrease in bandwidth, and an increase in current that is required to provide a desired power output. In the preferred embodiment, barrier layer 13 has a maximum thickness of approximately 3700 angstroms. Forming the barrier layer between the maximum and minimum thickness is an important improvement over previous LED's.

By now it should be appreciated that there has been provided a novel way to fabricate a small emission-spot LED that has a wide bandwidth and high efficiency. Creating a barrier layer that is between a critical maximum and minimum limit facilitates minimizing the LED's emission-spot while maximizing the LED's bandwidth and efficiency. Employing such a barrier layer results in an LED that has a bandwidth in excess of 100 MHz, and uses only 35 milliamps to provide an output power of approximately one milliwatt.

While the invention is described with specific preferred embodiments, it is evident that many alternatives and variations will be apparent to those skilled in the semiconductor arts. More specifically the invention has been described for a particular LED structure with a particular combination of GaAs and AlGaAs materials, although the method is directly applicable to other LEDs that use different materials, as well as LEDs with different structures.

## Claims

1. A light emitting diode having a small emission-spot characterized in:
a substrate (11) of a first conductivity type;
an isolation layer (12) of a second conductivity type on the substrate (11) wherein the isolation layer (12) blocks majority carrier current flow between the substrate (11) and the isolation layer (12);
an opening (23) through the isolation layer (12) to the substrate (11) wherein the opening (23) has sidewalls;
a barrier layer (13) covering the isolation layer (12) and the sidewalls wherein the barrier layer (13) forms an energy barrier, the barrier layer (13) having a thickness that is between approximately 800 angstroms and 3700 angstroms so that the energy barrier substantially eliminates minority carrier current flow from the isolation layer (12) through the barrier layer (13); and
an injection layer (14) of the first conductivity type on the barrier layer (13) wherein the injection layer (14) fills the opening (23).

2. The light emitting diode of claim 1 further including an aluminum gallium arsenide active layer (16) on the injection layer (14); an aluminum gallium arsenide window layer (17) on the active layer (16); a gallium arsenide cap layer (18) on the window layer (17) wherein the cap layer (18) has an emission opening (19) that is through the cap layer (18) and exposes a portion of the window layer (17), and wherein the emission opening (19) is centered to the opening (23); a first contact (21) covering the cap layer (18); and a second contact (22) covering an exposed surface of the substrate (11).

3. The light emitting diode of claim 1 wherein the substrate (11) is N-type gallium arsenide.

4. The light emitting diode of claim 3 wherein the isolation layer is P-type gallium arsenide.

5. The light emitting diode of claim 4 wherein the isolation layer (12) has a thickness between approximately 0.8 microns and 1.2 microns.

6. The light emitting diode of claim 1 wherein the opening (23) has a width between approximately 12 and 65 microns.

7. The light emitting diode of claim 1 or 3 or 4 wherein the barrier layer (13) is P-type aluminum gallium arsenide.

8. The light emitting diode of claim 1 wherein the energy barrier is formed by the barrier layer (13) having a first band gap that is larger than a second band gap of the isolation layer (12).
